# EUROPEAN PATENT APPLICATION

(11) **EP 2 524 905 A1**
(43) Date of publication of application: **21.11.2012**
(21) Application number: 11732812.0
(22) Date of filing: 14.01.2011
(51) Int. Cl.: C04B 35/00, C23C 14/08, C23C 14/34, H01L 21/203

(54) **In-Ga-O OXIDE SINTERED BODY, TARGET, OXIDE SEMICONDUCTOR THIN FILM, AND MANUFACTURING METHODS THEREFOR**

(30) Priority: 15.01.2010 JP 2010006831
(71) Applicant: Idemitsu Kosan Co., Ltd., Chiyoda-ku Tokyo 100-8321 (JP)
(72) Inventor: EBATA, Kazuaki, Sodegaura-shi Chiba 299-0293 (JP); TOMAI, Shigekazu, Sodegaura-shi Chiba 299-0293 (JP); YANO, Koki, Sodegaura-shi Chiba 299-0293 (JP)
(74) Representative: Gille Hrabal
(86) International application number: PCT/JP2011/000169
(87) International publication number: WO 2011/086940

(57) **Abstract**

An oxide sintered body including indium oxide of which the crystal structure substantially includes a bixbyite structure, wherein gallium atoms are solid-soluted in the indium oxide, and an atomic ratio Ga/(Ga + In) is 0.10 to 0.15.

## Description

### Technical Field

The invention relates to an In-Ga-O oxide sintered body, a target, an oxide semiconductor thin film, a method for manufacturing the same, and a thin film transistor provided with the oxide semiconductor thin film.

### Background Art

Field effect transistors, such as a thin film transistor (TFT), are widely used as the unit electronic device of a semiconductor memory integrated circuit, a high frequency signal amplification device, a device for a liquid crystal drive, or the like, and they are electronic devices which are currently most widely put into practical use. Of these, with significant improvement in displays in recent years, in various displays such as a liquid crystal display (LCD), an electroluminescence display (EL) and a field emission display (FED), a TFT is frequently used as a switching device which drives a display by applying a driving voltage to a display device.

As a material of a semiconductor layer (channel layer) which is a main component of a field effect transistor, a silicon semiconductor compound is used most widely. Generally, a silicon single crystal is used for the high frequency amplification device and the device for integrated circuits which need high-speed operation. On the other hand, an amorphous silicon semiconductor (amorphous silicon) is used for a device for driving a liquid crystal in order to satisfy the demand for realizing a large-sized display.

A thin film of amorphous silicon can be formed at relatively low temperatures. However, the switching speed thereof is slow as compared with that of a crystalline thin film. Therefore, when it is used as a switching device which drives a display, it may be unable to follow the display of a high-speed animation. Specifically, amorphous silicon having a mobility of 0.5 to 1 cm²/Vs could be used in a liquid crystal television of which the resolution is VGA. However, if the resolution is equal to or more than SXGA, UXGA and QXGA, a mobility of 2 cm²/Vs or more is required. Moreover, if the driving frequency is increased in order to improve the image quality, a further higher mobility is required.

On the other hand, a crystalline silicon thin film had problems that, although it has a high mobility, it required great energy and a large number of steps in the production and formation of large-area display was difficult. For example, when crystallizing a silicon-based thin film, laser annealing which is conducted at a high temperature of 800°C or higher and requires expensive equipment are required. Moreover, since the device configuration of a TFT was usually limited to the top-gate structure, reduction in cost, such as reduction of the number of masks, was difficult in the case of a crystalline silicon thin film.

In order to solve such a problem, a thin film transistor which uses an oxide semiconductor film which is formed of indium oxide, zinc oxide and gallium oxide has been studied. Generally, fabrication of an oxide semiconductor thin film is conducted by sputtering using a target (sputtering target) which consists of an oxide sintered body.

For example, a target which is formed of a compound having a homologous crystal structure represented by general formulas In₂Ga₂ZnO₇ and InGaZnO₄ is disclosed (Patent Documents 1, 2 and 3). However, in order to increase the sintering density (relative density) in this target, it is required to conduct sintering in the oxidizing atmosphere. However, in order to lower the resistance of a target in that case, a reduction treatment at high temperatures is required after sintering. Moreover, this target involves problems that the properties of the resulting film or the film-forming speed are greatly changed if the target is used for a long period of time, abnormal discharge occurs due to unusual growth of InGaZnO₄ or In₂Ga₂ZnO₇, particles are generated frequently at the time of film formation or other problems
If abnormal discharge occurs frequently, plasma discharge state will become unstable, and as a result, stable film-forming is not performed, thereby adversely affecting the film properties.

A sputtering target in which gallium oxide and germanium oxide are co-doped with indium oxide has been developed for conductive film applications (Patent Document 4).
Generation of nodules can be suppressed by substitutional solid-solution of gallium atoms and germanium atoms in oxide indium components in a sintered oxide body, whereby the maximum particle size of a crystal is allowed to be 5 µm or less. In Comparative Examples of Patent Document 4, production of an In₂O₃ target in which only Ga is doped and whether nodules are generated or not are demonstrated. This document reports that generation of nodules is significant. Not only the average particle diameter of the raw material powder used is as large as 1.8 to 2 µm and the firing time is as short as 6 hours, a phase other than the bixbyite structure of indium oxide may be formed in an oxide sintered body, causing generation of nodules.

As mentioned above, studies on a target used in the production of an oxide semiconductor film by the sputtering method were not sufficiently made.

### Related Art Document

### Patent Document

Patent Document 1: JP-A-08-245220
Patent Document 2: JP-A-2007-73312
Patent Document 3: WO2009/084537
Patent Document 4: JP-A-2008-285760

### Summary of the Invention

An object of the invention is to provide an oxide sintered body which can suppress abnormal discharge which occurs when an oxide semiconductor thin film is formed by the sputtering method and can form an oxide semiconductor thin film stably with a high reproducibility.

The inventors formed an oxide semiconductor thin film by the DC sputtering method by using a sputtering target in which the atomic ratio Ga/(In + Ga) is 0.10 to 0.15 in an oxide sintered body formed of a gallium element, an indium element and an oxygen element. As a result of intensive studies, the inventors have found that the crystal structure of the target and occurrence of abnormal discharge at the time of film formation have the following relationship. That is, the inventors have found that, while if the crystal of indium oxide of the target is formed substantially of the bixbyite structure, abnormal discharge does not occur if direct current is passed, if the crystal contains other structures such as GalnO₃ in addition to the bixbyite structure, abnormal discharge frequently occurs. Further, the inventors have found that, in the case of a target which is formed substantially of the bixbyite structure of indium oxide, occurrence of abnormal discharge can be suppressed. The invention has been made based on this finding.

According to the invention, the following oxide sintered body or the like are provided.
1. An oxide sintered body comprising indium oxide of which the crystal structure substantially comprises a bixbyite structure, wherein gallium atoms are solid-soluted in the indium oxide, and an atomic ratio Ga/(Ga + In) is 0.10 to 0.15.
2. The oxide sintered body according to 1, wherein the atomic ratio Ga/(Ga + In) is 0.12 to 0.15.
3. A method for producing the oxide sintered body according to 1 or 2 comprising the steps of:
   mixing indium oxide powder having an average particle size of 1.2 µm or less and gallium oxide powder having an average particle size of 1.2 µm or less such that the atomic ratio Ga/(Ga + In) becomes 0.10 to 0.15 to prepare mixture powder,
   shaping the mixture powder to produce a shaped body; and
   firing the shaped body at 1450°C to 1650°C for 10 hours or more.
4. The method for producing the oxide sintered body according to 3, wherein the firing is conducted in an oxidizing gas atmosphere.
5. A target which is obtained by processing the oxide sintered body according to 1 or 2.
6. An oxide semiconductor thin film which is obtained from the oxide sintered body according to 1 or 2 and has an atomic ratio Ga/(Ga + In) of 0.10 to 0.15.
7. The oxide semiconductor thin film according to 6 which is an oxide semiconductor thin film comprising indium oxide which substantially comprises a bixbyite structure as the crystal structure, wherein gallium atoms are solid-soluted in the indium oxide.
8. A thin film transistor having the oxide semiconductor thin film according to 6 or 7 as a channel layer.
9. A display which is provided with the thin film transistor according to 8.

According to the invention, it is possible to provide an oxide sintered body which can suppress abnormal discharge which occurs when an oxide semiconductor thin film is formed by the sputtering method and can form an oxide semiconductor thin film stably with a high reproducibility.

### Brief Description of the Drawings

FIG. 1 is a view showing the results of X-ray diffraction measurement of a sintered body produced in Example 1;
FIG 2 is a view showing the results of X-ray diffraction measurement of a sintered body produced in Example 2;
FIG 3 is a view showing the results of X-ray diffraction measurement of a sintered body produced in Example 3;
FIG 4 is a view showing the results of X-ray diffraction measurement of a sintered body produced in Example 4;
FIG 5 is a view showing the results of X-ray diffraction measurement of a sintered body produced in Example 5;
FIG 6 is a view showing the results of X-ray diffraction measurement of a sintered body produced in Example 6;
FIG. 7 is a view showing the results of X-ray diffraction measurement of a sintered body produced in Comparative Example 1;
FIG. 8 is a view showing the results of X-ray diffraction measurement of a sintered body produced in Comparative Example 2; and
FIG. 9 is a view showing the results of X-ray diffraction measurement of a sintered body
produced in Comparative Example 3.

### Mode for Carrying out the Invention

In the oxide sintered body of the invention, the crystal structure is formed of indium oxide of which the crystal structure substantially comprises a bixbyite structure, gallium atoms are solid-soluted in the indium oxide and an atomic ratio Ga/(Ga + In) is 0.10 to 0.15.

Since the oxide sintered body of the invention is formed of a single phase of indium oxide having a bixbyite structure in which gallium atoms are solid-soluted, occurrence of abnormal discharge when sputtering the target formed of the oxide sintered body of the invention can be suppressed.
Since the oxide sintered body of the invention is formed of a single phase of indium oxide having a bixbyite structure in which gallium atoms are solid-soluted, occurrence of cracks and generation of nodules in the target formed of the oxide sintered body of the invention can be reduced Therefore, the oxide sintered body is capable of forming a high-quality oxide semiconductor thin film efficiently at a low cost and in an energy-saving manner.
The above-mentioned bixbyite structure can be confirmed by X-ray diffraction.

In the invention, the "substantially" means that the advantageous effects of the invention are derived from the above-mentioned bixbyite structure or means that 90 vol% or more, preferably 95 vol% or more and further preferably 98 vol% or more of the above-mentioned crystal structure is indium oxide having a bixbyite structure.
Further, 90 vol% or more, preferably 95 vol% or more and further preferably 98 vol% or more of the oxide sintered body of the invention is formed of a crystal structure. It is preferred that 90 vol% or more of the oxide sintered body of the invention be formed of a crystal structure and 90 vol% or more of the crystal structure be indium oxide having a bixbyite structure.
The volume fraction can be calculated by the peak analysis of the X-ray diffraction.

By allowing the atomic ratio Ga/(In + Ga) to be 0.15 or less, it is possible to disperse Ga uniformly in an indium oxide crystal. On the other hand, if the atomic ratio Ga/(In + Ga) exceeds 0.15, Ga is no longer solid-soluted in the bixbyite structure of indium oxide, whereby other crystal structures such as GalnO₃ may be deposited. If the oxide sintered body of the invention contains other crystal structures such as GalnO₃, when sputtering the target formed of the oxide sintered body of the invention, abnormal discharge may occur easily, electrons may be scattered to lower the mobility and crystallization of indium oxide may be hindered.
As for the reason of the above-mentioned abnormal discharge, it can be assumed that, due to the un-uniformity of the target and the local presence of parts which differ in specific resistance, impedance of the discharge system that contains a target is varied during sputtering. The parts where the specific resistance locally differs are crystals such as GalnO₃, and it is effective to suppress occurrence of abnormal discharge to decrease the size and number density of these crystals.

If the atomic ratio Ga/(Ga + In) is less than 0.10, if a thin film is formed by using the target formed of the oxide sintered body of the invention, micro crystals may be generated in the thin film. If the thin film is heated in the post treatment, secondary crystallization occurs, and the mobility may be lowered or oxygen deficiency may be increased, whereby an increase in carrier density may be caused.

From the above-mentioned respects, the atomic ratio of metal gallium and indium metal Ga/(Ga + In) is preferably 0.10 to 0.15, more preferably 0.11 to 0.15, further preferably 0.12 to 0.15, with Ga/(Ga + In) of 0.12 to 0.14 being particularly preferable.

The atomic ratio of the each element contained in the oxide sintered body of the invention can be obtained by analyzing the elements contained by the Inductively Coupled Plasma Atomic Emission Spectroscopy (ICP-AES).
Specifically, in an analysis using ICP-AES, a sample solution is atomized by means of a nebulizer, and then introduced into argon plasma (about 6000 to 8000°C). The elements in the sample are excited by absorbing thermal energy, whereby orbit electrons are transferred from the ground state to an orbit with a higher energy level. These orbit electrons are transferred to an orbit with a lower energy level within about 10⁻⁷ to 10⁻⁸ seconds. At this time, difference in energy is radiated as light to cause emission. Since this light has a wavelength (spectral line) peculiar to the element, the presence of the element can be confirmed by the presence of the spectral line (qualitative analysis). Further, since the amplitude of each of the spectral line (emission intensity) increases in proportion to the number of elements contained in a sample, the concentration of a sample solution can be obtained by comparing a sample solution with a standard solution with a known concentration (quantitative analysis).
After identifying the element contained by a qualitative analysis, the content thereof is obtained by a quantitative analysis. From the results, the atomic ratio of each element is obtained.

The density of the oxide sintered body of the invention is preferably 6.2 g/cm³ or more, more preferably 6.4 g/cm³ or more.
If the density is less than 6.2 g/cm³, the surface of the sputtering target formed of the oxide sintered body of the invention may be blackened to induce abnormal discharge, leading to lowering of the sputtering speed. The density is particularly preferably 6.2 g/cm³ or more and 7.1 g/cm³ or less.

It is desired that the maximum particle size of the indium oxide crystal in which gallium atoms in the oxide sintered body are solid-soluted be 5 µm or less. If the indium oxide crystal is grown to have a particle size exceeding 5 µm, nodules may be generated.
When the target surface is ground by sputtering, the grinding speed differs depending on the direction of the crystal surface, whereby unevenness is generated on the target surface. It is assumed that, the size of this unevenness varies depending on the particle size of the crystal present in the sintered body, and in the target formed of a sintered body having a large crystal size, a greater scale of unevenness occurs, and nodules are generated from this convex part.

The maximum particle size of the above-mentioned oxide indium crystal is obtained as follows. If the sputtering target formed of the oxide sintered body of the invention has a circular shape, at five locations in total, i.e. the central point (one) and the points which are on the two central lines crossing orthogonally at this central point and are middle between the central point and the peripheral part, and if the sputtering target formed of the oxide sintered body of the invention has a square shape, at five locations in total, i.e. the central point (one) and middle points (four) between the central point and the corner of the diagonal line of the square, the maximum diameter is measured for the biggest particle observed within a 100-µm square. The maximum particle size is the average value of the particle size of the biggest particle present in each of the frames defined by the five locations. As for the particle size, the longer diameter of the crystal particle is measured.
The crystal particles can be observed by the scanning electron microscopy (SEM).

In the oxide sintered body of the invention, gallium atoms are dispersed in the solid solution state. It is preferred that the diameter of the aggregate of the dispersed gallium atoms be less than 1 µm. By allowing gallium atoms to be finely dispersed, stable sputtering discharge can be conducted.
The diameter of the aggregate of the gallium atoms can be measured by means of an EPMA (electron probe micro-analyzer).

The film-forming speed at the time of DC sputtering depends on the specific resistance of the oxide sintered body of the sputtering target. Therefore, in respect of productivity, a lower specific resistance of the oxide sintered body of the invention is preferable. The specific resistance of the oxide sintered body of the invention is preferably 10 Qcm or less, more preferably 1 Qcm or less. If the specific resistance of the oxide sintered body exceeds 10 Ωcm, it may be difficult to conduct stable film formation by DC sputtering.
The specific resistance of the oxide sintered body can be reduced by a reduction treatment which is conducted in the production process of the sintered body mentioned later in which the sintered body is heated in a non-oxidizing atmosphere such as nitrogen.

However, even though the specific resistance of the oxide sintered body is 10 Ωcm or less, stable DC sputtering cannot necessarily be conducted. Even if the specific resistance of the entire oxide sintered body is 10 Qcm or less, if a high-resistant material phase having a specific resistance exceeding 10 Ωcm is locally contained in the oxide sintered body (for example, the above-mentioned GalnO₃ phase or the like), this part is electrically charged due to the irradiation of sputtering gas ion to cause abnormal discharge. As a result, DC sputtering cannot be conducted stably.
Therefore, it is important that the specific resistance of the entire oxide sintered body is 10 Ωcm or less, without locally containing the high-resistant phase.

The oxide sintered body of the invention is formed of gallium elements, indium elements and oxygen elements, and composed substantially of indium oxide having a bixbyite structure. Within a range which does not impair the advantageous effects of the invention, impurities which are inevitably mixed in may be contained.

The method of producing an oxide sintered body of the invention comprises the steps of:
mixing indium oxide powder having an average particle size of 1.2 µm or less and gallium oxide powder having an average particle size of 1.2 µm or less such that the atomic ratio Ga/(Ga + In) becomes 0.10 to 0.15 to prepare mixture powder;
shaping the mixture powder to produce a shaped body; and
firing the shaped body at 1450°C to 1650°C for 10 hours or more.

The oxide sintered body of the invention is not restricted by the production method thereof, and can be produced from the combination of metal gallium and indium oxide. It is preferred that indium oxide and gallium oxide be used as raw material powder.
If indium oxide and metal gallium are used as the raw material powder, metal particles of gallium are present in the resulting oxide sintered body. The metal particles on the target surface are molten during the film formation, and hence do not discharged from the target. As a result, the composition of the resulting film and the composition of the oxide sintered body may differ greatly.

The indium oxide powder and the gallium oxide powder as the raw material both have an average particle size of 1.2 µm or less, preferably 1.0 µm or less. By allowing the average particle size of the raw material powder to be 1.2 µm or less and by controlling the firing time, it is possible to produce an oxide sintered body which is composed substantially of the bixbyite structure of indium oxide in which gallium atoms are uniformly solid-soluted and dispersed.
The average particle size of the above-mentioned raw material powder can be measured by a laser diffraction particle size analyzer.

In₂O₃ powder and Ga₂O₃ powder are mixed such that the atomic ratio Gal(In + Ga) becomes 0.10 to 0.15.
By allowing the atomic ratio Ga/(In + Ga) to be 0.15 or less, it is possible to obtain an oxide sintered body which is formed substantially of indium oxide having a bixbyite structure.

As for the method for mixing the raw material powder, a wet or dry ball mill, a vibration mill, a beads mill or the like can be used. In order to obtain uniform and fine crystal particles and voids, the most preferable method is a beads mill mixing method since it can pulverize the aggregate efficiently for a short period of time and can realize a favorable dispersed state of additives.

When a ball mill is used for mixing, the mixing time is preferably 15 hours or more, more preferably 19 hours or more. If the mixing time is insufficient, a crystal structure different from a bixbyite structure such as GalnO₃ may be generated in the resulting oxide sintered body.
When a beads mill is used for mixing, the mixing time is varied depending on the size of the apparatus used and the amount of slurry to be treated. However, the mixing time is controlled such that the particle distribution in the slurry becomes uniform (all of the grains have a grain size of 1 µm or less).

At the time of mixing, an arbitral amount of a binder is added, and mixing may be conducted together with the binder.
As the binder, polyvinyl alcohol, vinyl acetate or the like can be used.

The slurry of the mixed raw material powder is granulated to obtain granulated powder. The granulated powder is then shaped to produce a shaped body.
For granulation, it is preferable to use quick dry granulation. As the apparatus for quick dry granulation, a spray dryer is widely used. Specific drying conditions are determined according to conditions such as the concentration of slurry to be dried, the temperature of hot air used for drying and the amount of wind. For actually conducting the quick dry granulation, it is required to obtain optimum conditions in advance.
In natural drying, since the speed of sedimentation differs due to the difference in specific gravity of the raw material powder, separation of In₂O₃ powder and Ga₂O₃ powder occurs, and as a result, uniform granulated powder may not be obtained. If a sintered body is made by using this un-uniform granulated powder, GalnO₃ or the like may be generated inside the sintered body, causing abnormal discharge during sputtering.

The granulated powder can be shaped by means of a mold press or a cold isostatic pressing (CIP). The pressure at the time of shaping is 1.2 ton/cm² or more for example.

For sintering the resulting shaped body, in addition to the atmospheric sintering pressing, a pressure sintering method such as hot pressing, oxygen pressurization and hot isostatic pressing or the like can be used.
In respect of decrease in production cost, possibility of mass production and easiness in production of a large-sized sintered body, it is preferable to use atmospheric sintering pressing.

In the atmospheric sintering pressing, a shaped body is sintered in the atmosphere or the oxidizing gas atmosphere. Preferably, a shaped body is sintered in the oxidizing gas atmosphere.
The oxidizing gas atmosphere is preferably an oxygen gas atmosphere. It suffices that the oxidizing gas atmosphere be an atmosphere having an oxygen concentration of 10 to 100 vol%, for example. When the oxide sintered body of the invention is fabricated, the density of the oxide sintered body can be further increased by introducing an oxygen gas atmosphere during the heating step.

Firing is conducted at a temperature of 1450 to 1650°C. Further, the firing time is 10 hours or longer and 50 hours or shorter.
If the firing temperature is lower than 1450°C or the firing time is shorter than 10 hours, Ga is not solid-soluted in indium oxide crystals, and a GalnO₃ phase or the like may be formed inside the target, causing abnormal discharge. On the other hand, if the firing temperature exceeds 1650°C or the firing time exceeds 50 hours, the average crystal particle size may be increased and generation of large voids due to significant growth of crystal particles, whereby the strength of the sintered body may be decreased or abnormal discharge may occur.

By allowing the firing temperature to be 1650°C or less, evaporation of Ga can be suppressed.
The firing temperature is preferably 1450 to 1600°C, further preferably 1480 to 1600°C, with 1500 to 1600°C being particularly preferable.
The firing time is preferably 10 to 50 hours, further preferably 12 to 40 hours, with 15 to 30 hours being particularly preferable.

As for the heating rate at the time of firing, it is preferred that the heating rate be 1 to 15°C/min in the firing temperature range of 500 to 1500°C.
A temperature range of 500 to 1500°C is a range where sintering proceeds most quickly. If the heating rate in this temperature range is less than 1°C/min, growth of crystal particles becomes significant, whereby an increase in density may not be attained. On the other hand, if the heating rate exceeds 15°C/min, since the uniformity in heat in the sintering furnace is lowered, and the amount of shrinkage during sintering may be varied due to a lowering of soaking properties in the sintering furnace, whereby the sintered body is broken.

In the method for producing the oxide sintered body of the invention, for the resulting sintered body, a reduction step may further be provided if need arises. A reduction step is a step provided in order to allow the bulk resistance of the sintered body obtained in the above-mentioned firing step to be uniform in the entire target.

As the reduction method which can be used in the reduction step, a reduction treatment by a reductive gas, vacuum firing, a reduction treatment by an inert gas or the like can be given.
In the case of a reduction treatment by firing in a reductive gas, hydrogen, methane, carbon monoxide, or a mix gas of these gases with oxygen or the like can be used.
In the case of a reduction treatment by firing in an inert gas, nitrogen, argon, or a mix gas of these gases with oxygen or the like can be used.
The temperature at the time of the above-mentioned reduction treatment is normally 100 to 800°C, preferably 200 to 800°C. The reduction treatment is conducted normally for 0.01 to 10 hours, preferably 0.05 to 5 hours.

In summary, a water-based solvent is compounded with raw material powder containing mixed powder of indium oxide powder and gallium oxide powder, for example, and the resulting slurry is mixed for 12 hours or longer. Thereafter, the slurry is subjected to solid-liquid separation, dried and granulated. Subsequently, the granulated product is put in a mold and shaped. Therefore, the resulting shaped product is fired in an oxygen atmosphere for 1450 to 1650°C for 10 hours or longer, whereby an oxide sintered body can be obtained.

By controlling the conditions in the production process of the sintered body as mentioned above, it is possible to obtain an oxide sintered body having a sintered density of 6.0 g/cm³ or more, a specific resistance of 10 Ωcm or less, and an average crystal particle size of 10 µm or less and formed only substantially of a bixbyite structure of indium oxide in which gallium atoms are solid-soluted.

A sputtering target can be obtained by processing the oxide sintered body of the invention. Specifically, the oxide sintered body of the invention is cut into a form which is suited for being mounted in a sputtering apparatus, whereby a sputtering target can be obtained.
Specifically, in order to allow the oxide sintered body to be a target material, the sintered body is ground by means of a plane grinder to allow the surface roughness Ra to be 5 µm or less. Further, the sputtering surface of the target material may be subjected to mirror finishing, thereby allowing the average surface roughness thereof Ra to be 1000Å or less. For this mirror finishing (polishing), known polishing techniques such as mechanical polishing, chemical polishing, mechano-chemical polishing (combination of mechanical polishing and chemical polishing) or the like may be used. For example, it can be obtained by polishing by means of a fixed abrasive polisher (polishing liquid: water) to attain a roughness of #2000 or more, or can be obtained by a process in which, after lapping by a free abrasive lap (polisher: SiC paste or the like), lapping is conducted by using diamond paste as a polisher instead of the SiC paste. There are no specific restrictions on these polishing methods.

It is preferable to finish the surface of the target material by means of a #200 to #10,000 diamond wheel, particularly preferably by means of a #400 to #5,000 diamond wheel. If a diamond wheel with a mesh size of smaller than #200 or a diamond wheel with a mesh size of larger than #10,000 is used, the target material may be broken easily.

It is preferred that the surface roughness Ra of the target material be 0.5 µm or less and that the grinding surface has no directivity. If Ra is larger than 0.5 µm or the grinding surface has directivity, abnormal discharge may occur or particles may be generated.

Subsequently, the thus processed sintered body is subjected to a cleaning treatment. For cleaning, air blowing, washing with running water or the like can be used. When foreign matters are removed by air blowing, foreign matters can be removed more effectively by air intake by means of a dust collector from the side opposite from the nozzle. Since the above-mentioned air blow or washing with running water has its limit, ultrasonic cleaning or the like can also be conducted. In ultrasonic cleaning, it is effective to conduct multiplex oscillation within a frequency range of 25 to 300 KHz. For example, it is preferable to perform ultrasonic cleaning by subjecting 12 kinds of frequency composed of every 25 KHz in a frequency range of 25 to 300 KHz to multiplex oscillation.

The thickness of the target material is normally 2 to 20 mm, preferably 3 to 12 mm and particularly preferably 4 to 6 mm.

By bonding the target material obtained in the manner as mentioned above to a backing plate, a sputtering target formed of the oxide sintered body of the invention can be obtained. A plurality of target materials may be provided in a single backing plate to use as a substantially single target.

It is desirable that the target formed of the oxide sintered body of the invention have a higher density. The density is preferably 6.2 g/cm³ or more and 7.1 g/cm³ or less.

By forming a film using the target formed of the oxide sintered body of the invention, the oxide semiconductor thin film of the invention can be obtained.
The above-mentioned film formation can be conducted by the deposition method, the sputtering method, the ion plating method, the pulse laser deposition method or the like. An oxide semiconductor thin film which can be formed by the sputtering method or the like by using the oxide sintered body of the invention, since gallium is solid-soluted in indium oxide crystals, it is possible to allow the lattice constant to be small. As a result, the 5s orbits of indiums in the crystal is overlapped to a higher degree, whereby improvement of mobility can be expected.

An explanation will be made hereinbelow on the formation of the oxide semiconductor thin film of the invention on the substrate by sputtering.
Since the oxide sintered body of the invention has a high conductivity, it is possible to apply the DC sputtering method which has a high film-forming speed. Further, the oxide sintered body of the invention can be applied to, in addition to the above-mentioned DC sputtering method, the RF sputtering method, the AC sputtering method and the pulse DC sputtering method, and hence, sputtering free from abnormal discharge is possible.

As the sputtering gas, a mixed gas of argon and an oxidizing gas can be used. Examples of the oxidizing gas include O₂, CO₂, O₃ and H₂O.
The oxygen partial pressure at the time of film formation by sputtering is preferably 5% or more and 40% or less. A thin film formed under the conditions in which the oxygen partial pressure is less than 5% has conductivity, and hence, it may be difficult to use as an oxide semiconductor. The oxygen partial pressure is preferably 10% or more and 40% or less.

The substrate temperature at the time of film formation is 500°C or less, for example, preferably 10°C or more and 400°C or less, further preferably 20°C or more and 350°C or less, with 80°C or more and 300°C or less being particularly preferable.

By subjecting the thin film on the substrate which is formed by sputtering to an annealing treatment, the thin film is crystallized and semiconductor properties can be obtained. Further, by subjecting to an annealing treatment, in the oxide semiconductor thin film of the invention, Ga is solid-soluted in oxide indium crystals, whereby the oxide sintered body shows a single phase of bixbyite.

The annealing treatment temperature is 500°C or less, for example, and preferably 100°C or more and 500°C or less, further preferably 150°C or more and 400°C or less, with 200°C or more and 350°C or less being particularly preferable.

The heating atmosphere of the film formation and the annealing treatment is not particularly restricted. In respect of carrier control properties, the air atmosphere and the oxygen-circulating atmosphere are preferable.
In the annealing treatment, in the presence or absence of oxygen, a lamp annealing apparatus, a laser annealing apparatus, a thermal plasma apparatus, a hot air heating apparatus, a contact heating apparatus or the like can be used.

The oxide semiconductor thin film of the invention thus obtained is substantially composed of indium oxide which has a bixbyite structure, in which gallium is solid-soluted in indium oxide. The atomic ratio in the thin film Ga/(Ga + In) is 0.10 to 0.15.
The above-mentioned atomic ratio Ga/(Ga + In) is preferably 0.12 to 0.15.

The oxide semiconductor thin film of the invention can be used in a thin film transistor, and can be preferably used in the channel layer of the thin film transistor.
The thin film transistor which is provided with the oxide semiconductor thin film of the invention as a channel layer (hereinafter often referred to as the thin film transistor of the invention) may be of channel etch type. Since the oxide semiconductor thin film of the invention is a crystalline film which has durability, in the production of the thin film transistor of the invention, it is possible to conduct a photolithographic step in which a thin film of a metal such as Al is etched to form source/drain electrodes and a channel part.

The thin film transistor of the invention may be of etch stopper type. In the oxide, semiconductor thin film of the invention, the etch stopper can protect the channel part formed of the semiconductor layer. In addition, incorporation of a large amount of oxygen in the semiconductor layer at the time of film formation eliminates the need of supply of oxygen from outside through the etch stopper layer. Further, immediately after the film formation, an amorphous film can be formed. As a result, a thin film of a metal such as Al can be etched to form source/drain electrodes and a channel part, and at the same time, the semiconductor layer can be etched to shorten the photolithographic process.

### EXAMPLES

### [Production of an oxide sintered body and a target]

### Examples 1 to 6

Indium oxide powder having an average particle size of 0.98 µm and oxide gallium powder having an average particle size of 0.96 µm were weighed such that the atomic ratio Ga/(Ga + In) shown in Table 1 was attained. After pulverizing and mixing homogenously, a binder for shaping was added and granulated. Subsequently, this raw material mixed powder was uniformly filled in a mold. Then, the powder was press-molded at a pressure of 140 MPa by means of a cold press machine. The thus obtained shaped body was fired in a sintering furnace at a firing temperature for a firing time shown in Table 1, whereby a sintered body was produced.
The firing atmosphere was the oxygen atmosphere when heating. Firing was conducted in the air (atmosphere) when other treatments than heating were conducted. Firing was conducted at a heating rate of 1°C/min and at a cooling rate of 15°C/min.
The average particle size of the raw material oxide powder was measured by means of a laser diffraction particle size analyzer (SALD-300V, manufactured by Shimadzu Corporation), and as the average particle size, the median diameter D50 was used.

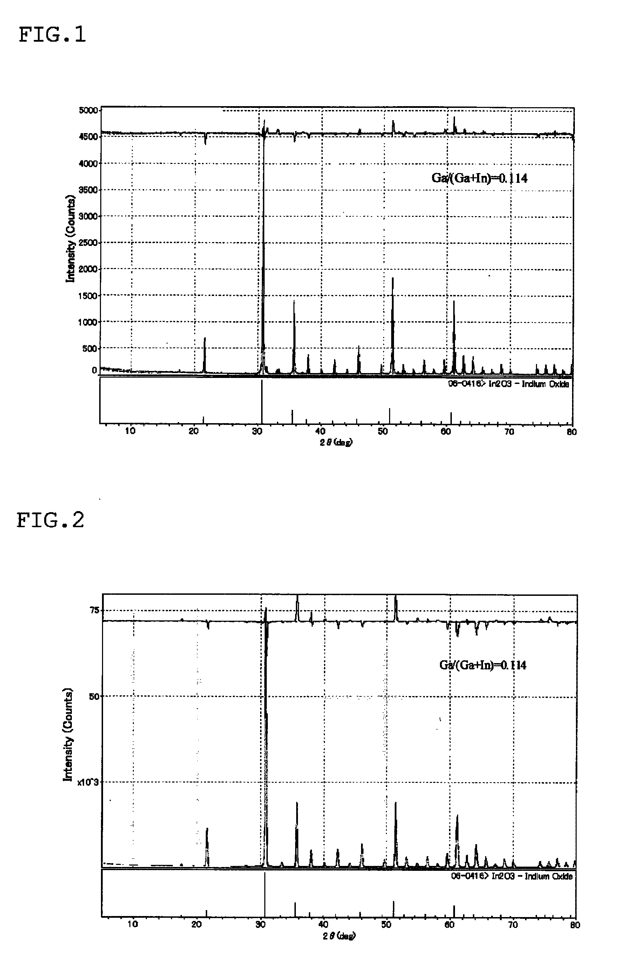

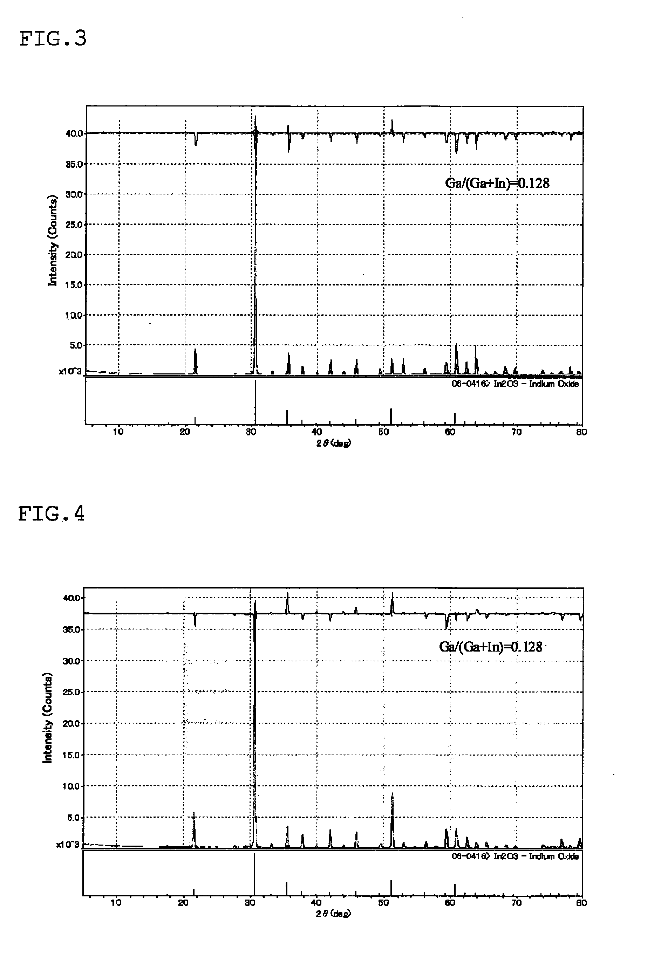

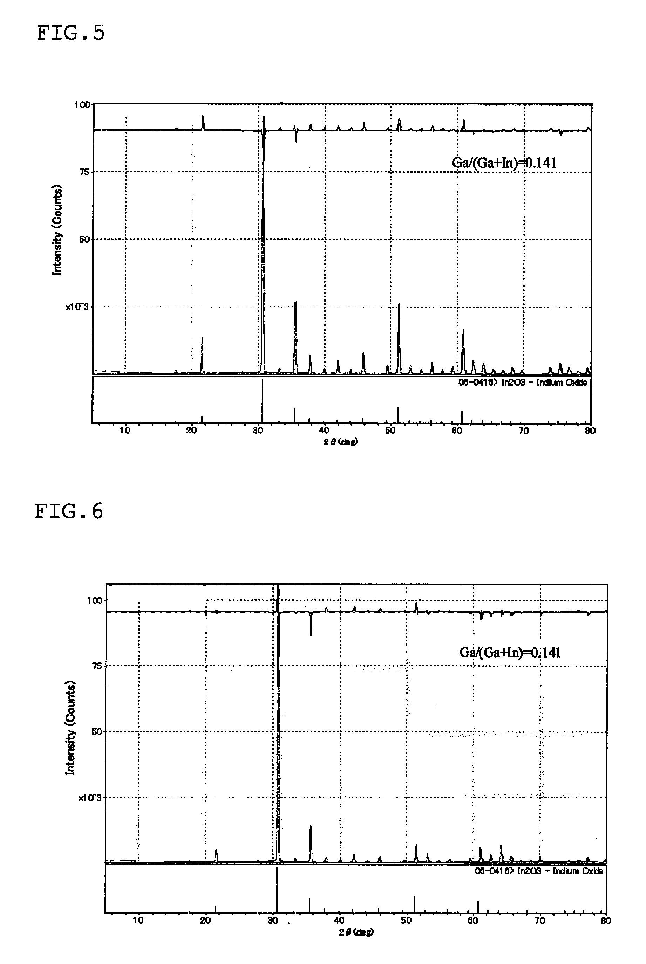

For the resulting sintered body, the crystal structure was examined by means of an X-ray diffraction measurement apparatus (Ultima-III, manufactured by Rigaku Corporation). X-ray charts of the sintered bodies obtained in Examples 1 to 6 are respectively shown in FIGs. 1 to 6.
As a result of analysis of the charts, in the sintered bodies in Examples 1 to 6, only the bixbyite structure of indium oxide was observed. This crystal structure could be confirmed by the JCPDS (Joint Committee of Powder Diffraction Standards) cards. The bixbyite structure of indium oxide was No. 06-0416 of the JCPDS card.

The measuring conditions of the X-ray diffraction measurement (XRD) are as follows.
Apparatus: Ultima-III, manufactured by Rigaku Corporation
X rays: Cu-Kα rays (wavelength: 1.5406Å, monochromatized by means of a graphite monochrometer) 2θ-θ reflection method, continuous scanning (1.0°/min)
Sampling interval: 0.02°
Slit DS, SS: 2/3°, RS: 0.6 mm

The density of the resulting sintered body was calculated from the weight and the external dimension of the sintered body which had been cut into a specific size. The bulk resistance (conductivity) of the resulting sintered body was measured by the four probe method (JIS R1637) using a resistivity meter (Loresta, manufactured by Mitsubishi Chemical Corporation).

For the resulting sintered body, dispersion of Ga was examined by the measurement of EPMA. As a result, an aggregate of gallium atoms each having a size of 1 µm or more was not observed, and it was understood that the sintered bodies in Examples 1 to 6 were significantly excellent in dispersibility and uniformity.

The measuring conditions of EPMA are as follows.
Name of apparatus: JXA-8200 manufactured by JEOL Ltd.
Acceleration voltage: 15 kV
Irradiation current: 50 nA
Irradiation time (per point): 50 mS

The surfaces of the oxide sintered bodies obtained in Examples 1 to 6 were ground by means of a plane grinder. The corners were cut by means of a diamond cutter and the oxide sintered bodies were laminated to a backing plate, whereby sputtering targets each having a diameter of 4 inches were obtained.

The resulting sputtering targets were mounted in a DC sputtering apparatus. Argon was used as the sputtering gas, and 10kWh continuous sputtering was conducted under the following conditions:
Sputtering pressure: 0.4 Pa
Substrate temperature: room temperature
DC output: 400 W
Variations in voltage during sputtering were stored in a data logger to confirm occurrence of abnormal discharge. The results are shown in Table 1.
Occurrence of the above-mentioned abnormal discharge was confirmed by detecting abnormal discharge by monitoring variations in voltage. Specifically, a case where variations in voltage which occur during a 5-minute measurement accounted for 10% or more of the working voltage during the sputtering operation was evaluated as abnormal discharge. In particular, when the working voltage varies ±10% in 0.1 sec during the sputtering operation, a micro-arc which is abnormal discharge of sputtering discharge may have occurred. In such a case, the yield of a device may be lowered, leading to difficulty in mass production of a device.

Further, by using the sputtering targets in Examples 1 to 6, and by using as the atmosphere a mixed gas in which 3% hydrogen gas was added to an argon gas, sputtering was conducted continuously for 30 hours. Occurrence of nodules was confirmed. As a result, on the surface of the sputtering targets in Examples 1 to 6, no nodules were observed.
The sputtering conditions were as follows.
Sputtering pressure: 0.4 Pa, DC output: 100W, Substrate temperature: room temperature Hydrogen gas was added to the atmosphere gas in order to promote generation of nodules.
As for observation of the nodules, a change in the target surface was observed by means of a stereoscopic microscope (magnification: × 50), and the average number of nodules with a size of 20 µm or more which were generated in a viewing field of 3 mm² was calculated. The number of generated nodules was shown in Table 1.

**Table 1**

| | Ga/(Ga+In) | Firing temperature [°C] | Firing time [hr] | Crystal strcture | Density of sintered body [g/cm³] | Bulk resistance [m Ω cm] | Occurrence of abnormal discharge during sputtering | Number of generated nodules [number/3mm²] |
|---|---|---|---|---|---|---|---|---|
| Example 1 | 0.114 | 1500 | 20 | Bixbyite | 6.22 | 6.2 | None | 0 |
| Example 2 | 0.114 | 1600 | 13 | Bixbyite | 6.43 | 2.7 | None | 0 |
| Example 3 | 0.128 | 1500 | 20 | Bixbyite | 6.85 | 2.9 | None | 0 |
| Example 4 | 0.128 | 1600 | 15 | Bixbyite | 6.47 | 6.2 | None | 0 |
| Example 5 | 0.141 | 1500 | 20 | Bixbyite | 6.37 | 4.3 | None | 0 |
| Example 6 | 0.141 | 1600 | 16 | Bixbyite | 6.52 | 5.7 | None | 0 |

### Comparative Examples 1 to 3

Sintered bodies and targets were produced and evaluated in the same manner as in Examples 1 to 6, except that indium oxide powder having an average particle size of 0.98 µm and gallium oxide powder having an average particle size of 0.96 µm were weighed such that the atomic ratio Ga/(In + Ga) shown in Table 2 was attained. The results are shown in Table 2.
As is understood from Table 2, in the sputtering targets of Comparative Examples 1 to 3, abnormal discharge occurred and nodules were observed on the target surface.

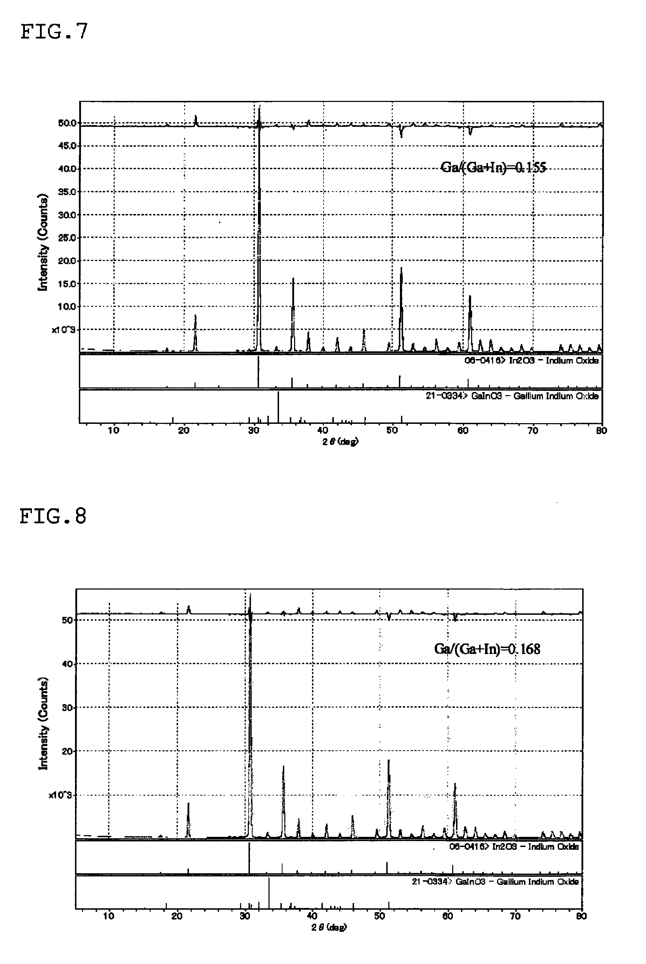

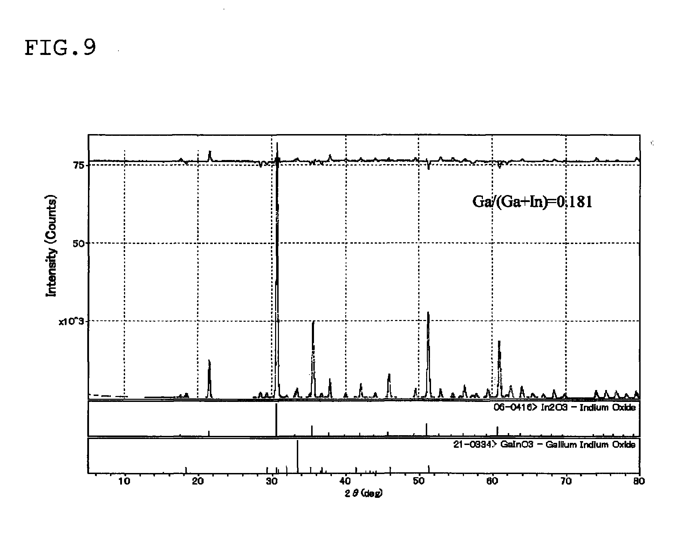

Charts obtained by the X-ray diffraction of the sintered bodies in Comparative Examples 1 to 3 are respectively shown in FIGs. 7 to 9.
In the sintered bodies in Comparative Examples 1 to 3, in the X-ray diffraction chart, in addition to the bixbyite structure, a GalnO₃ phase was observed. This crystal structure can be confirmed by the JCPDS cards. The GalnO₃ phase can be confirmed by the JCPDS No. 21-0334. Further, the crystal structure of the GalnO₃ phase is monoclinic.

**Table 2**

| | Ga/(Ga+In) | Firing temperature [°C] | Firing time [hr] | Crystal structure | Density of sintered body [g/cm³] | Bulk resistance [m Ω cm] | Occurrence of abnormal discharge during sputtering | Number of generated nodules [number/3mm²] |
|---|---|---|---|---|---|---|---|---|
| Com. Ex. 1 | 0.155 | 1300 | 10 | Bixbyite, monoclinic | 6.21 | 16.2 | Micro arc occurred | 18 |
| Com. Ex. 2 | 0.168 | 1350 | 12 | Bixbyite, monoclinic | 6.43 | 18.1 | Micro arc occurred | 21 |
| Com. Ex. 3 | 0.181 | 1400 | 12 | Bixbyite, monoclinic | 6.26 | 33.5 | Micro arc occurred | 43 |

### [Formation of an oxide semiconductor thin film and production of a thin film transistor]

### Example 7

On a glass substrate and a silicon substrate provided with a 100 nm-thick thermally oxidized film (SiO₂), a 50 nm-thick thin film was respectively formed by the DC magnetron sputtering method by using the target (Ga/(In + Ga)) = 0.114) obtained in Example 1.
Sputtering was conducted as follows. After conducting vacuum evacuation until the back pressure became 5 × 10⁻⁴ Pa, the pressure was adjusted to 0.4 Pa by flowing argon at 9 sccm and oxygen at 1 sccm. Sputtering was conducted at a sputtering power of 100 W at room temperature.

The crystal structure, immediately after the film formation, of the thin film formed on the glass substrate was confirmed by XRD. As a result, no clear diffraction peaks were observed, demonstrating that the film was amorphous. The glass substrate on which this thin film was formed was put in a heating furnace heated to 300°C in the air, and a treatment was conducted for 1 hour.
XRD measurement was conducted for the thin film after the annealing treatment, and only a peak derived from the bixbyite structure of indium oxide was observed. This crystal structure can be confirmed by the JCPDS card No. 06-0416.
The carrier concentration and the mobility of the thin film after the annealing treatment were evaluated by the Hall effect measurement. As a result, it was found that the carrier concentration was 5.84 × 10¹⁷ cm⁻³ and a Hall mobility was 25.8 cm²/Vs.

The hall measurement apparatus and the measurement conditions thereof were as follows.

### [Hall measurement apparatus]

Resi Test 8310, manufactured by Toyo Technica Co., Ltd.

### -Measurement conditions

Measurement temperature: Room temperature (about 25°C)
Magnetic field for measurement: 0.45T
Current for measurement: 10⁻¹² to 10⁻⁴A
Measurement mode: AC magnetic field hall measurement

For the thin film formed on the silicon substrate, a metal mask was provided on the conductive silicon substrate, and a channel part with a length (L) of 200 µm and a width (W) of 1,000 µm was formed. Then, gold was deposited to form source/drain electrodes. The device was put in a heating furnace which was heated to 300°C, and a treatment was conducted for 1 hour, whereby a thin film transistor was produced.

For the thus produced thin film transistor, evaluation was made on the field effect mobility, the on-off ratio and the S-value. As a result, it was confirmed that the field effect mobility was 47.6 cm²/Vs, the on-off ratio was 8.18 × 10⁷ (normally-off properties), and the S-value was 1.16.
The measurement was conducted by using a semiconductor parameter analyzer (Keithley 4200) at room temperature, in air and in the light-shielded environment.

### Example 8

On a glass substrate and a silicon substrate provided with a 100 nm-thick thermally oxidized film (SiO₂), a 50 nm-thick thin film was respectively formed by the DC magnetron sputtering method by using the target (Ga/(In + Ga)) = 0.128) obtained in Example 3.
Sputtering was conducted as follows. After conducting vacuum evacuation until the back pressure became 5 × 10⁻⁴ Pa, the pressure was adjusted to 0.4 Pa by flowing argon at 8.5 sccm and oxygen at 1.5 sccm. Sputtering was conducted at a sputtering power of 100 W at room temperature.

The crystal structure, immediately after the film formation, of the thin film formed on the glass substrate was confirmed by XRD. As a result, no clear diffraction peaks were observed, demonstrating that the film was amorphous. The glass substrate on which this thin film was formed was put in a heating furnace heated to 300°C in the air, and a treatment was conducted for 1 hour.
XRD measurement was conducted for the thin film after the annealing treatment, and as a result, only a peak derived from the bixbyite structure of indium oxide was observed. This crystal structure can be confirmed by the JCPDS card No. 06-0416.
The carrier concentration and the mobility after the annealing treatment were evaluated by the Hall effect measurement. As a result, it was found that the carrier concentration was 3.23 × 10¹⁷ cm⁻³ and a Hall mobility was 24.5 cm²/Vs.

For the thin film formed on the silicon substrate, a metal mask was provided on the conductive silicon substrate, and a channel part with a length (L) of 200 µm and a width (W) of 1,000 µm was formed. Then, gold was deposited to form source/drain electrodes. The device was put in a heating furnace which was heated to 300°C, and a treatment was conducted for 1 hour, whereby a thin film transistor was produced.

For the thus produced thin film transistor, evaluation was made on the field effect mobility, the on-off ratio and the S-value. As a result, it was confirmed that the field effect mobility was 48.2 cm²/Vs, the on-off ratio was 3.67 × 10⁷ (normally-off properties), and the S-value was 1.23.

### Comparative Example 4

Sintered bodies and targets were produced in the same manner as in Example 1, except that indium oxide powder and gallium oxide powder were weighed such that the atomic ratio Gal(In + Ga) became 0.029.
On a glass substrate and a silicon substrate provided with a 100 nm-thick thermally oxidized film (SiO₂), a 50 nm-thick thin film was respectively formed by the DC magnetron sputtering method by using the target (Gal(In + Ga)) = 0.029) obtained.
Sputtering was conducted as follows. After conducting vacuum evacuation until the back pressure became 5 × 10⁻⁴ Pa, the pressure was adjusted to 0.4 Pa by flowing argon at 9 sccm and oxygen at 1 sccm. Sputtering was conducted at a sputtering power of 100 W at room temperature.

The crystal structure, immediately after the film formation, of the thin film formed on the glass substrate was confirmed by XRD. As a result, clear diffraction peaks were observed, demonstrating that the film had the bixbyite structure of indium oxide and was crystalline. This crystal structure can be confirmed by the JCPDS card No. 06-0416. The glass substrate on which this thin film was formed was put in a heating furnace heated to 300°C in the air, and a treatment was conducted for 1 hour.
The carrier concentration and the mobility after the annealing treatment were evaluated by the Hall effect measurement. As a result, it was found that the carrier concentration was 5.3 × 10¹⁸ cm⁻³ and a Hall mobility was 10.2 cm²/Vs. The thin film after the annealing treatment was a thin film having a carrier density of 10¹⁸cm⁻³ or more, suffering from a large amount of oxygen deficiency. The Hall mobility was inferior to the thin films in Examples 7 and 8.

For the thin film formed on the silicon substrate, a metal mask was provided on the conductive silicon substrate, and a channel part with a length (L) of 200 µm and a width (W) of 1,000 µm was formed. Then, gold was deposited to form source/drain electrodes. The device was put in a heating furnace which was heated to 300°C, and a treatment was conducted for 1 hour, whereby a thin film transistor was produced.

For the thus produced thin film transistor, evaluation was made on the field effect mobility, the on-off ratio and the S-value. As a result, it was confirmed that the field effect mobility was 17.2 cm²/Vs, the on-off ratio was 4.5 × 10⁸ (normally-on properties), and the S-value was 3.27.

### Comparative Example 5

A sintered body and a target were produced in the same manner as in Example 1, except that indium oxide powder and gallium oxide powder were weighed such that the atomic ratio Gal(In + Ga) became 0.015.
On a glass substrate and a silicon substrate provided with a 100 nm-thick thermally oxidized film (SiO₂), a 50 nm-thick thin film was respectively formed by the DC magnetron sputtering method by using the target (Ga/(In + Ga)) = 0.015) obtained.
Sputtering was conducted as follows. After conducting vacuum evacuation until the back pressure became 5 × 10⁻⁴ Pa, the pressure was adjusted to 0.4 Pa by flowing an argon gas at 9 sccm and oxygen at 1 sccm. Sputtering was conducted at a sputtering power of 100 W at room temperature.

The crystal structure, immediately after the film formation, of the thin film formed on the glass substrate was confirmed by XRD. As a result, clear diffraction peaks were observed, demonstrating that the film had the bixbyite structure of indium oxide and was crystalline. This crystal structure can be confirmed by the JCPDS card No. 06-0416. The glass substrate on which this thin film was formed was put in a heating furnace heated to 300°C in the air, and a treatment was conducted for 1 hour.
The carrier concentration and the mobility after the annealing treatment were evaluated by the Hall effect measurement As a result, it was found that the carrier concentration was 9.78 × 10¹⁸ cm⁻³ and a Hall mobility was 11.5 cm²/Vs. The thin film after the annealing treatment was a thin film has a carrier density of 10¹⁸ cm⁻³ or more, suffering from a large amount of oxygen deficiency The Hall mobility was inferior to the thin films in Examples 7 and 8.

For the thin film formed on the silicon substrate, a metal mask was provided on the conductive silicon substrate, and a channel part with a length (L) of 200 µm and a width (W) of 1,000 µm was formed. Then, gold was deposited to form source/drain electrodes. The device was put in a heating furnace which was heated to 300°C, and a treatment was conducted for 1 hour, whereby a thin film transistor was produced.

For the thus produced thin film transistor, evaluation was made on the field effect mobility, the on-off ratio and the S-value. As a result, it was confirmed that the field effect mobility was 19.5 cm²/Vs, the on-off ratio was 4.64 × 10⁶ (normally-on properties), and the S-value was 3.88.

### Industrial Applicability

The sputtering target of the invention can be used for the production of a thin film transistor or the like. Further, the thin film transistor of the invention can be used in an integrated circuit or the like.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.
The documents described in the specification are incorporated herein by reference in its entirety.

## Claims

1. An oxide sintered body comprising indium oxide of which the crystal structure substantially comprises a bixbyite structure, wherein gallium atoms are solid-soluted in the indium oxide, and an atomic ratio Ga/(Ga + In) is 0.10 to 0.15.

2. The oxide sintered body according to claim 1, wherein the atomic ratio Ga/(Ga + In) is 0.12 to 0.15.

3. A method for producing the oxide sintered body according to claim 1 or 2 comprising the steps of:
mixing indium oxide powder having an average particle size of 1.2 µm or less and gallium oxide powder having an average particle size of 1.2 µm or less such that the atomic ratio Ga/(Ga + In) becomes 0.10 to 0.15 to prepare mixture powder;
shaping the mixture powder to produce a shaped body; and
firing the shaped body at 1450°C to 1650°C for 10 hours or more.

4. The method for producing the oxide sintered body according to claim 3, wherein the firing is conducted in an oxidizing gas atmosphere.

5. A target which is obtained by processing the oxide sintered body according to claim 1 or 2.

6. An oxide semiconductor thin film which is obtained from the oxide sintered body according to claim 1 or 2 and has an atomic ratio Ga/(Ga + In) of 0.10 to 0.15.

7. The oxide semiconductor thin film according to claim 6 which is an oxide semiconductor thin film comprising indium oxide which substantially comprises a bixbyite structure as the crystal structure, wherein gallium atoms are solid-soluted in the indium oxide.

8. A thin film transistor having the oxide semiconductor thin film according to claim 6 or 7 as a channel layer.

9. A display which is provided with the thin film transistor according to claim 8.
